# DEMANDE DE BREVET EUROPEEN

(11) **EP 4 379 797 A1**
(43) Date de publication de la demande: **05.06.2024**
(21) Numéro de dépôt: 23212234.1
(22) Date de dépôt: 27.11.2023
(51) Int. Cl.: H01L 23/52, H01L 23/498, H01L 23/522

(54) **DISPOSITIF ÉLECTRONIQUE**

(30) Priorité: 30.11.2022 FR 2212593
(71) Demandeur: Commissariat à l'énergie atomique et aux énergies alternatives, 75015 Paris (FR)
(72) Inventeur: BOURJOT, Emilie, 38054 GRENOBLE CEDEX 09 (FR); LAVIRON, Cyrille, 38054 GRENOBLE CEDEX 09 (FR); CHARBONNIER, Jean, 38054 GRENOBLE CEDEX 09 (FR); LAMY, Yann, 38054 GRENOBLE CEDEX 09 (FR)
(74) Mandataire: Thibon, Laurent

(57) **Abrégé**

La présente description concerne un interposeur (12) comprenant des condensateurs (32) ayant une densité supérieure à 700 nF/mm^2, avantageusement supérieure à 1 µF/mm^2, l'interposeur étant adapté à être fixé à une puce (14) par collage hybride.

## Description

### Domaine technique

La présente description concerne de façon générale les dispositifs électroniques et plus particulièrement les dispositifs comprenant une puce et un interposeur.

### Technique antérieure

Les dispositifs électroniques comprennent souvent des interposeurs, permettant de former des connexions électriques entre une puce principale, fixée sur un premier côté de l'interposeur, et une ou plusieurs puces secondaires, fixées sur un deuxième côté de l'interposeur.

La puce principale est par exemple un circuit intégré. Les puces secondaires comprennent par exemple des composants discrets ou des circuits associés au circuit intégré, par exemple pour permettre au circuit intégré d'effectuer des fonctions ne pouvant être effectuées par la puce principale.

Les interposeurs sont généralement constitués d'une couche, par exemple en un matériau isolant électriquement, des vias conducteurs et une ou plusieurs pistes conductrices permettant de former des niveaux de routage pour les interconnexions. L'interposeur comprend par exemple des plots de contact sur ses premier et deuxième côtés, les plots de contact étant reliés à des plots de contact des puces principales et secondaires, par exemple par des billes de soudure. Une telle connexion permet en outre de fixer les puces à l'interposeur.

Il existe un besoin de placer des condensateurs dans les interposeurs, de manière à optimiser la fourniture de puissance aux différentes puces secondaires. En particulier, il existe un besoin de réduire significativement les inductances équivalentes (ESR) et les résistances équivalentes (ESL) parasites, de manière à augmenter grandement l'efficacité des condensateurs. De manière conventionnelle, la connexion des condensateurs, par exemple discrets, sur une puce active se fait par connexion filaire ou par billes métalliques ayant des dimensions de l'ordre du micromètre. Ces connexions génèrent elles-mêmes des inductances (5 à 100 pH) et/ou des résistances (20-100 mOhms) parasites. Ces inductances ou résistances parasites sont équivalentes ou dépassent même les inductances ou résistances parasites des condensateurs très haute performance (1 pF/mm2).

### Résumé de l'invention

Il existe un besoin de connecter des condensateurs très hautes performances avec d'autres sans dégrader leurs performances intrinsèques avec des parasites des connexions.

Un mode de réalisation prévoit un interposeur comprenant des condensateurs ayant une densité supérieure à 700 nF/mm^2, avantageusement supérieure à 1 µF/mm^2, l'interposeur étant adapté à être fixé à une puce par collage hybride.

Selon un mode de réalisation, l'interposeur comprend : un substrat traversé par des premiers vias conducteurs ; une première couche, recouvrant le substrat, dans laquelle sont situés les condensateurs ; et un réseau d'interconnexion comprenant des plots de contact adaptés au collage moléculaire.

Selon un mode de réalisation, les premiers vias ont un diamètre compris entre 5 µm et 20 µm, avantageusement sensiblement égal à 10 µm, et une hauteur comprise entre 50 µm et 200 µm, avantageusement sensiblement égale à 100 µm.

Selon un mode de réalisation, la première couche comprend des premières régions conductrices, chaque première région étant en contact avec une extrémité d'un premier via, et étant reliée à un plot de contact par des vias conducteurs et pistes conductrices du réseau d'interconnexion.

Selon un mode de réalisation, les premières régions sont entourées latéralement par des deuxièmes régions isolantes.

Selon un mode de réalisation, l'interposeur comprend : des troisièmes régions dans lesquelles sont situés les condensateurs, des quatrièmes régions isolantes, chaque condensateur étant entouré latéralement par une quatrième région isolante, des cinquièmes régions conductrices, chaque cinquième région étant séparée d'une troisième région par une quatrième région, et des sixièmes régions conductrices, chaque sixième région reliant une borne d'un condensateur à une cinquième région, chaque cinquième région étant reliée à un plot de contact par des deuxièmes vias conducteurs et pistes conductrices du réseau d'interconnexion, une autre borne de chaque condensateur étant reliée à un plot de contact par des deuxièmes vias conducteurs et pistes conductrices du réseau d'interconnexion.

Selon un mode de réalisation, chaque région isolante de la première couche est en un métal anodisé.

Selon un mode de réalisation, les condensateurs comprennent un empilement d'une deuxième couche conductrice, d'une troisième couche isolante, d'une quatrième couche conductrice, chaque troisième région étant en un métal anodisé comprenant une pluralité de cavités traversant ledit métal, l'empilement recouvrant les parois desdites cavités.

Selon un mode de réalisation, l'interposeur comprend, dans au moins une zone, une densité de plots supérieure à 10^3 plots par mm^2.

Un autre mode de réalisation prévoit un dispositif comprenant un interposeur tel que décrit précédemment et au moins une première puce fixée à une première face de l'interposeur, la au moins une première puce étant fixée à la première face par collage moléculaire.

Selon un mode de réalisation, la formation du condensateur comprend : - la formation d'une cinquième couche en un matériau conducteur ; - la formation de cavités à l'emplacement du condensateur dans la cinquième couche par un procédé de gravure anodique ; et - la formation, de manière conforme, d'un empilement d'une couche conductrice, d'une couche isolante et d'une couche conductrice à l'emplacement du condensateur.

Selon un mode de réalisation, la formation des régions isolantes de la première couche est obtenue par un procédé de gravure anodique d'une partie de la cinquième couche.

Selon un mode de réalisation, le procédé comprend : - la formation des premiers vias dans le substrat ; - la formation d'une septième région conductrice s'étendant de l'emplacement de chaque troisième région à l'emplacement de la cinquième région correspondante ; - la formation du condensateur, de telle manière qu'une borne du condensateur soit en contact avec la septième région.

Selon un mode de réalisation, la cinquième couche est en aluminium.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente schématiquement un mode de réalisation d'un dispositif électronique ;
la figure 2 représente une étape d'un procédé de fabrication d'un mode de réalisation d'un dispositif électronique du type du dispositif de la figure 1 ;
la figure 3 représente une étape d'un procédé de fabrication d'un mode de réalisation d'un dispositif électronique du type du dispositif de la figure 1 ;
la figure 4 représente une étape d'un procédé de fabrication d'un mode de réalisation d'un dispositif électronique du type du dispositif de la figure 1 ;
la figure 5 représente une étape d'un procédé de fabrication d'un mode de réalisation d'un dispositif électronique du type du dispositif de la figure 1 ; et
la figure 6 représente une étape d'un procédé de fabrication d'un mode de réalisation d'un dispositif électronique du type du dispositif de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Sauf précision contraire, les expressions "isolant" et "conducteur" signifient "isolant électriquement" et "conducteur électriquement".

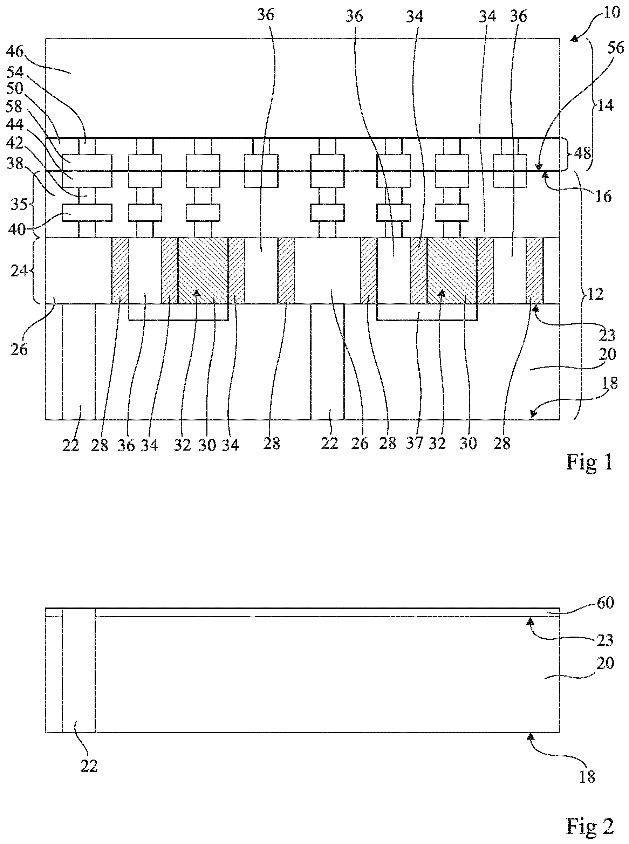

La figure 1 représente schématiquement un mode de réalisation d'un dispositif électronique 10.

Le dispositif 10 comprend un interposeur 12. Le dispositif 10 comprend en outre une puce 14 fixée sur une face supérieure 16 de l'interposeur 12. Bien que, en figure 1, une seule puce 14 ne soit représentée, le dispositif 10 peut comprendre une pluralité de puces 14 fixées sur la face 16 de l'interposeur 12. L'interposeur 12 comprend une face inférieure 18, opposée à la face 16. La face 18 est fixée à une puce, par exemple une unique puce, non représentée ou à un substrat de matrice de billes (Ball Grid Array ou BGA). La face 18 et la puce non représentée sont par exemple fixées l'une à l'autre par des billes de soudure non représentées.

L'interposeur comprend une couche 20 en un matériau isolant. La couche 20 est par exemple en une résine. La couche 20 est par exemple en oxyde de silicium. La couche 20 est par exemple en un matériau semiconducteur, par exemple en silicium. La couche 20 est traversée par des vias traversants 22. Les vias 22 sont des vias conducteurs. Les vias 22 sont en un matériau conducteur, par exemple en métal. Les vias 22 s'étendent d'une face supérieure 23 de la couche 20, à la face inférieure de la couche 20, correspondant par exemple à la face 18 de l'interposeur. Autrement dit, les vias 22 s'étendent sur toute la hauteur de la couche 20. Les vias 22 ont par exemple un diamètre compris entre 5 µm et 20 µm, avantageusement sensiblement égal à 10 µm, et une hauteur par exemple comprise entre 50 µm et 200 µm, avantageusement sensiblement égale à 100 µm.

Chaque via 22 correspond par exemple à une connexion entre l'interposeur 12 et la puce non représentée à laquelle l'interposeur est relié. L'interposeur 12 comprend par exemple au moins autant de vias 22 que de connexions voulues entre l'interposeur et la puce non représentée. L'interposeur 12 comprend par exemple au moins autant de vias 22 que de connexions voulues entre les puces 14 et la puce non représentée.

L'interposeur 12 comprend une couche 24 en un matériau conducteur anodisable, de préférence en métal. La couche 24 est par exemple en aluminium, en magnésium ou en tantale.

La couche 24 comprend des régions 26. Les régions 26 sont des régions conductrices. Les régions 26 sont situées en regard des vias 22. Les régions 26 s'étendent sur toute la hauteur de la couche 24. Les régions 26 s'étendent donc de la face supérieure de la couche 20, à la face supérieure de la couche 24. Chaque région 26 est en contact avec une extrémité supérieure d'un via 22, c'est-à-dire en contact avec l'extrémité d'un via 22 affleurant la face supérieure de la couche 20. Chaque région 26 permet de continuer la liaison électrique du via 22 avec lequel la région 26 est en contact.

Les régions 26 sont entourées par des régions 28 de la couche 24. Les régions 28 sont des régions isolantes. Les régions 28 sont en le matériau de la couche 24, par exemple en aluminium, ayant été anodisé, par exemple en alumine. Les régions 28 sont ainsi des régions poreuses. Autrement dit, les régions 28 comprennent une pluralité de cavités, ou nanopores, non représentées, s'étendant par exemple sur toute la hauteur de la région 28.

La couche 24 comprend en outre des régions 30, dans lesquelles sont situés des condensateurs 32. Chaque région 30 comprend par exemple un unique condensateur 32. Les condensateurs 32 sont des condensateurs haute densité, c'est-à-dire des condensateurs ayant une densité supérieure à 700 nF/mm^2, par exemple supérieure à 1 µF/mm^2.

Les régions 30 sont, comme les régions 28, en le matériau de la couche 24, par exemple en aluminium ayant été anodisé, par exemple en alumine. Les régions 30 comprennent ainsi une pluralité de cavités non représentées, s'étendant par exemple sur toute la hauteur de la région 30. La densité de cavités dans la région 30 est par exemple supérieure à 40 cavités/µm^2.

Les condensateurs 32 sont des condensateurs Métal-isolant-métal ou MIM. Chaque condensateur 32 comprend un empilement de couches non représenté en figure 1, d'une couche isolante située entre deux couches conductrices, de préférence en métal. L'empilement de couches d'un condensateur 32 est situé de manière conforme sur la structure poreuse de la région 30.

Une couche inférieure de l'empilement d'un condensateur 32, c'est-à-dire une des couches conductrices, de préférence une couche métallique, s'étend de manière conforme sur la structure poreuse, et en particulier dans les cavités de la région 30. La couche inférieure d'un condensateur 32 recouvre, de préférence entièrement, la face supérieure de la couche 24 dans la région 30, les parois latérales des cavités, et le fond des cavités. La couche inférieure d'un condensateur 32 affleure ainsi la face inférieure de la couche 24.

Une couche intermédiaire de l'empilement d'un condensateur 32, c'est-à-dire la couche isolante, s'étend de manière conforme sur la couche inférieure. La couche intermédiaire s'étend dans les cavités. La couche intermédiaire recouvre de préférence entièrement la couche inférieure.

Une couche supérieure de l'empilement d'un condensateur 32, c'est-à-dire l'autre couche conductrice, par exemple en métal, s'étend de manière conforme sur la couche intermédiaire. La couche supérieure s'étend dans les cavités. La couche supérieure remplit par exemple les cavités. La couche supérieure recouvre de préférence entièrement la couche intermédiaire. La couche supérieure comprend par exemple une face supérieure plane s'étendant au-dessus de la face supérieure de la structure poreuse.

La couche 24 comprend en outre des régions 34 isolantes délimitant les régions 30. Chaque région 30 est entourée de régions 34. Chaque région 30 est ainsi isolée latéralement du reste de la couche 24. Chaque région 30 est de préférence directement en contact latéral avec les régions 34. Ainsi, les régions 30 ne sont de préférence pas séparées des régions 34, par d'autres régions de la couche 24. En particulier, les régions 30 ne sont de préférence pas séparées des régions 34 par des régions du matériau de la couche 24 n'ayant pas été anodisé et n'étant pas poreux.

Les régions 34 sont des régions isolantes. Les régions 34 sont en le matériau de la couche 24, par exemple en aluminium ayant été anodisé, par exemple en alumine. Les régions 34 sont ainsi des régions poreuses. Autrement dit, les régions 34 comprennent une pluralité de cavités non représentées, s'étendant par exemple sur toute la hauteur de la région 34.

La couche 24 comprend en outre des régions 36 conductrices. Les régions 36 sont des régions du matériau de la couche 24 n'ayant pas été anodisées et n'étant pas poreuses. Chaque région 36 s'étend sur toute la hauteur de la couche 24. Ainsi, chaque région 36 s'étend de la face inférieure de la couche 24 à la face supérieure de la couche 24. Chaque région 36 est entourée latéralement par des régions 28 et/ou 34. De préférence, la couche 24 comprend au moins autant de régions 36 que de condensateurs 32. De préférence, une région 36 est voisine de chaque région 30, les régions 30 et 36 sont de préférence séparées uniquement par une région 34. La face inférieure de chaque région 30, c'est-à-dire la couche inférieure de chaque condensateur 32, est reliée électriquement à une région 36, de préférence la région 36 voisine. Ainsi, une borne du condensateur 32 de chaque région 30 est reliée, par l'intermédiaire de la couche 36, à la face supérieure de la couche 24.

Dans l'exemple schématique de la figure 1, la face inférieure de chaque région 30 est reliée à la région 36 par une région conductrice 37 située dans la couche 20. Alternativement, la face inférieure de chaque région 30 peut être reliée à la région 36 par une région conductrice 37, différente de la région 37 représentée en figure 1, s'étendant, dans la couche 24, sous les régions 30, 34 et 36, de manière à être en contact avec la couche inférieure du condensateur 32 de la région 30 et avec une extrémité inférieure de la région 36 voisine. Une telle couche 37 est par exemple au moins partiellement, par exemple entièrement, en le matériau des régions 26. Une telle structure sera décrite plus en détail en relation avec les figures 2 à 6.

L'interposeur 12 comprend en outre un réseau d'interconnexion 35. Autrement dit, l'interposeur 12 comprend un empilement 35 de couches 38 isolantes, dans lesquelles sont situées des pistes conductrices 40 et des vias conducteurs 42. Le réseau 35 est situé sur la face supérieure de la couche 24. Autrement dit, le réseau 35 est séparé de la couche 20 par la couche 24.

La couche supérieure de l'empilement 35, c'est-à-dire la couche la plus éloignée de la couche 24, comprend des plots 44 destinés à permettre le collage moléculaire de l'interposeur 12 à la puce 14. Les plots 44 affleurent la face supérieure de l'empilement 35. Les plots 44 permettent de plus la liaison électrique entre l'interposeur 12 et la puce 14, et donc la liaison électrique entre la puce 14 et une puce non représentée fixée à la face 18 de l'interposeur. Les plots 44 permettent en outre la connexion entre deux puces 14 adjacentes. De préférence, la face supérieure de l'interposeur comprend, sur au moins une partie de sa surface, une densité de plots 44 supérieure à 10^3/mm^2.

Chaque région 26 est reliée à un plot 44 par une ou plusieurs pistes 40 et un ou plusieurs vias. Ainsi, des connexions sont faites entre la face supérieure 16 de l'interposeur et la face inférieure 18 de l'interposeur, par l'intermédiaire d'un via 22, d'une région 26, des pistes 40 et vias 42, et un plot 44.

Similairement, chaque borne de chaque condensateur 32, c'est-à-dire chacune des deux couches conductrices entourant la couche isolante de chaque condensateur 32, est reliée à un plot 44. Ainsi, la couche supérieure de chaque condensateur 32 est reliée à un plot 44 par l'intermédiaire de pistes 40 et de vias 42. La couche inférieure de chaque condensateur 32 est reliée à un plot 44 par l'intermédiaire d'une région 37, d'une région 36, de pistes 40 et de vias 42.

La puce 14 comprend une partie principale 46, par exemple un substrat semiconducteur dans lequel sont formés des composants électroniques, par exemple des transistors, par exemple des transistors à effet de champ à grille isolée (MOSFET ou *Metal Oxide Semiconductor Field Effect Transistor).*

La puce 14 comprend en outre un réseau d'interconnexion 48. Autrement dit, la puce 14 comprend un empilement 48 de couches isolantes 50, dans lesquelles sont situées des pistes conductrices, non représentées, et des vias conducteurs 54. Le réseau 48 est situé sur une face inférieure 56 de la partie 46.

La couche inférieure de l'empilement 48, c'est-à-dire la couche la plus éloignée de la partie 46, comprend des plots 58 destinés à permettre le collage moléculaire de l'interposeur 12 à la puce 14. Les plots 58 affleurent la face inférieure de l'empilement 48. Les plots 58 permettent de plus la liaison électrique entre l'interposeur 12 et la puce 14, et donc la liaison électrique entre la puce 14 et une puce non représentée fixée à la face 18 de l'interposeur.

L'interposeur 12 et la puce 14 sont fixés l'un à l'autre par collage moléculaire. Plus précisément, la face 56 de la puce 14 est fixée par collage moléculaire à la face 16 de l'interposeur 12.

Les figures 2 à 6 représentent des étapes, de préférence successives, d'un procédé de fabrication d'un mode de réalisation d'un dispositif électronique du type du dispositif de la figure 1. Plus précisément, les figures 2 à 6 représentent la formation d'une partie d'un mode de réalisation d'un dispositif électronique du type du dispositif de la figure 1 comprenant un via 22, une région 26, une région 28, une région 36, une région 24, deux régions 34, une partie du réseau 35 et une partie de la puce 14.

La figure 2 représente une étape d'un procédé de fabrication d'un mode de réalisation d'un dispositif électronique du type du dispositif de la figure 1.

Au cours de cette étape, une couche isolante 60 est formée sur la couche 20. Plus précisément, la couche 60 est formée sur la face 23 de la couche 20. La couche 60 recouvre par exemple toute la face 23 de la couche 20. La couche 20 est par exemple en silicium. La couche 60 est par exemple en oxyde de silicium.

L'étape de la figure 2 comprend en outre la formation des vias 22. Les vias 22 traversent la couche 60 et la couche 20. Plus précisément, les vias s'étendent de la face inférieure 18 de la couche 20 à la face supérieure de la couche 60, c'est-à-dire la face de la couche 60 la plus éloignée de la couche 20. Par exemple, la formation des vias comprend la gravure de cavités traversant la couche 60 et partiellement la couche 20, le remplissage des cavités avec le matériau conducteur des vias 22, et l'amincissement de la couche 20 par la face inférieure 18 de manière à découvrir les faces inférieures des vias 22.

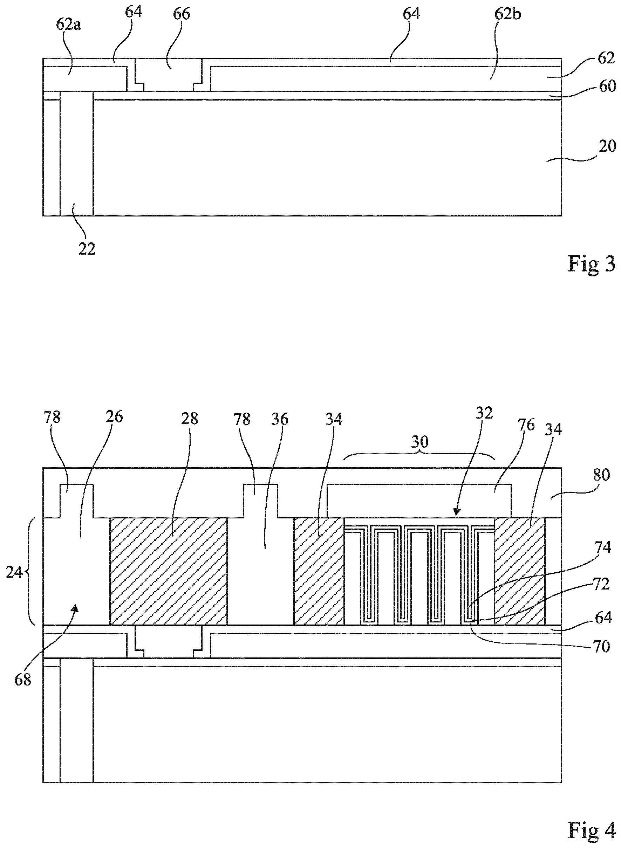

La figure 3 représente une étape d'un procédé de fabrication d'un mode de réalisation d'un dispositif électronique du type du dispositif de la figure 1.

Au cours de cette étape, une couche 62 en un matériau conducteur est formée. La couche 62 est par exemple en un métal, par exemple en le matériau de la couche 24, plus précisément le matériau de la région 26, par exemple en aluminium. La couche 62 comprend des première portions 62a et des deuxièmes portions 62b.

Chaque portion 62a, dont une seule est représentée en figure 3, est située en regard d'un via 22, et en contact avec ledit via 22. Chaque portion 62a recouvre ainsi la face supérieure d'un via 22 et la face supérieure de la couche 62 située autour de la face supérieure dudit via 22.

Chaque portion 62b, dont un seule est représentée en figure 3, est située en regard de l'emplacement d'un condensateur 32 et d'une région 36. Chaque portion 62b recouvre, de préférence uniquement, et est en contact avec la couche 60. Chaque portion 62b correspond à une région 37, c'est-à-dire une région conductrice de contact avec la borne du condensateur la plus proche de la couche 20.

Chaque portion 62a, 62b de la couche 62 est recouverte d'une couche 64 conductrice. La couche 64 est par exemple en métal, par exemple en un empilement de couches de nitrure de titane, de titane et d'aluminium ou en tungstène. La face supérieure et les faces latérales de chaque portion 62a, 62b sont recouverte par une couche 64. Par exemple, chaque couche 64 recouvre partiellement la face supérieure de la couche 60 située entre les différentes portions 62a, 62b. Au moins une partie de la face supérieure de la couche 60 située entre les différentes portions 62a, 62b n'est pas recouverte par une couche 64. Les couches 64 recouvrant des portions 62a, 62b différentes ne sont donc pas en contact l'une avec l'autre.

Les portions 62a, 62b sont séparées les unes des autres par des portions 66 isolantes, par exemple en oxyde de silicium. Chaque région 66 est située en regard de l'emplacement d'une région 28.

Les portions 66 remplissent, de préférence entièrement des cavités situées entre les portions 62a, 62b et entre les couches 64. Les portions 66 recouvrent ainsi les parties des couches 64 recouvrant les parois latérales des portions 62a, 62b et les parties des couches 64 recouvrant la face supérieure de la couche 60. Les portions 66 recouvrent en outre les parties de la couche 60 situées entre les couches 64, c'est-à-dire les parties de la couche 60 n'étant recouverts ni par les portions 62a, 62b ni par les couches 64. Les portions 62a, 62b sont ainsi isolées électriquement les unes des autres.

De préférence, la face supérieure de la structure résultant de l'étape de la figure 3 est plane. Autrement dit, les faces supérieures des régions 66 et les faces supérieures des parties des couches 64 situées sur les faces supérieures des portions 62a, 62b sont sensiblement coplanaires.

La figure 4 représente une étape d'un procédé de fabrication d'un mode de réalisation d'un dispositif électronique du type du dispositif de la figure 1.

Au cours de cette étape, la couche 24 est formée. Plus précisément, une couche 68 en le matériau de la région 26 est formée sur la structure résultant de l'étape de la figure 3. Autrement dit, la couche 68 recouvre, de préférence entièrement, les faces supérieures des régions 66 et les faces supérieures des parties des couches 64 situées sur les faces supérieures des portions 62a, 62b.

La couche 68 est en un matériau conducteur. La couche 68 est une couche complète et continue. La couche 68 ne comprend de préférence pas, lors de son dépôt, de cavités. De préférence, les faces inférieure et supérieure de la couche 68, c'est-à-dire la couche la plus proche de la couche 20 et la couche la plus éloignée de la couche 20, sont planes et parallèles. La couche 68 est par exemple en aluminium.

L'étape de la figure 4 comprend en outre la formation des nanopores dans les régions 28, 30 et 34 de la couche 68. Pour une question de clarté, les nanopores des régions 28 et 34 ne sont pas représentées dans les figures 4, 5 et 6, et uniquement quatre nanopores, sont représentés dans la région 30 des figures 4, 5 et 6.

Lors de la formation des nanopores dans les régions 28, 30 et 34, les portions de la couche 68 correspondant aux régions 28, 30 et 34 subissent un procédé de gravure anodique, permettant de réaliser une couche de métal nanostructurée. Le procédé de gravure anodique est par exemple précédé de la formation de masque sur la couche 68 en dehors des emplacements des régions 28, 30 et 34.

L'anodisation, ou procédé de gravure anodique, est un procédé électrolytique se déroulant en milieu humide. Le principe repose sur l'application d'une différence de potentiel imposée entre deux électrodes conductrices plongées dans une solution électrolytique, pouvant par exemple être acide. Dans l'exemple du procédé des figures 2 à 6, une des électrodes conductrices, par exemple l'anode, est la couche 68. L'application d'un potentiel à une électrode induit une croissance d'alumine à sa surface si l'électrode est en aluminium. La dissolution de l'électrode en aluminium dans le bain d'acide provoque l'apparition de nanopores ou de cavités dans la surface de l'électrode.

Les nanopores ont par exemple avantageusement un diamètre de l'ordre de 80 nm et sont espacés de 50 nm. La densité de nanopores est par exemple sensiblement égale à 40 cavités/µm². De plus, le procédé d'anodisation utilisé permet l'obtention de nanopores débouchant sur la couche 64. En d'autres termes, les nanopores peuvent être considérés comme des nano-cylindres dont un coté débouche sur la couche 64.

Le procédé de la figure 4 comprend en outre la formation de l'empilement de couches du condensateur 32. Plus précisément, le condensateur 32 comprend un empilement d'une couche conductrice 70, d'une couche isolante 72 et d'une couche conductrice 74 formées de manière conforme dans la région 30, comme décrit en relation avec la figure 1.

Ainsi, la couche 70, correspondant à la couche inférieure de l'empilement du condensateur 32, de préférence une couche métallique, s'étend de manière conforme sur la structure à nanopores, et en particulier à l'intérieur des nanopores de la région 30. La couche inférieure du condensateur 32 recouvre, de préférence entièrement, la face supérieure de la couche 24 dans la région 30, les parois latérales des nanopores, et le fond des nanopores. La couche inférieure du condensateur 32 affleure ainsi la face inférieure de la couche 24. La couche inférieure du condensateur 32 est donc reliée électriquement, de préférence en contact, avec la couche 64 située sous le condensateur 32.

La couche 72, correspondant à la couche intermédiaire de l'empilement du condensateur 32 s'étend de manière conforme sur la couche 70. La couche 72 s'étend dans les nanopores. La couche intermédiaire recouvre de préférence entièrement la couche 70.

La couche 74, correspondant à la couche supérieure de l'empilement du condensateur 32, par exemple en métal, s'étend de manière conforme sur la couche 72. La couche 74 s'étend dans les nanopores. La couche 74 remplit par exemple les nanopores. La couche 74 recouvre de préférence entièrement la couche 72. La couche 74 comprend par exemple une face supérieure plane s'étendant au-dessus de la face supérieure de la structure à nanopores.

L'étape de la figure 4 comprend de préférence la formation d'une région conductrice 76 recouvrant la couche 74. La région 76 est par exemple en métal. La région 76 recouvre de préférence entièrement la face supérieure de la couche 74. La région 76 recouvre par exemple partiellement les régions 34 entourant la région 30. La région 76 n'est pas en contact avec les régions 36 voisines. A cette étape, la région 76 n'est reliée électriquement qu'à la couche 74.

L'étape de la figure 4 comprend par exemple la formation de régions 78 situées chacune, de préférence uniquement, sur les régions 26 et 36. Les régions 78 sont de préférence en le matériau des régions 26 et 36, par exemple en aluminium. Les régions 78 sont en contact avec les régions 26, 36 sur lesquelles elles reposent.

L'étape de la figure 4 comprend par exemple la formation d'une couche isolante 80. La couche 80 recouvre de préférence entièrement la structure. La couche 80 recouvre ainsi, la face supérieure de la région 28, les faces supérieures et latérales des régions 76 et 78 et les portions des faces supérieures des régions 26, 34 et 36 n'étant recouvertes par les régions 76 et 78.

Le procédé de formation du condensateur 32 est par exemple décrit de manière plus détaillée dans les documents WO2015/063420 et EP3680931.

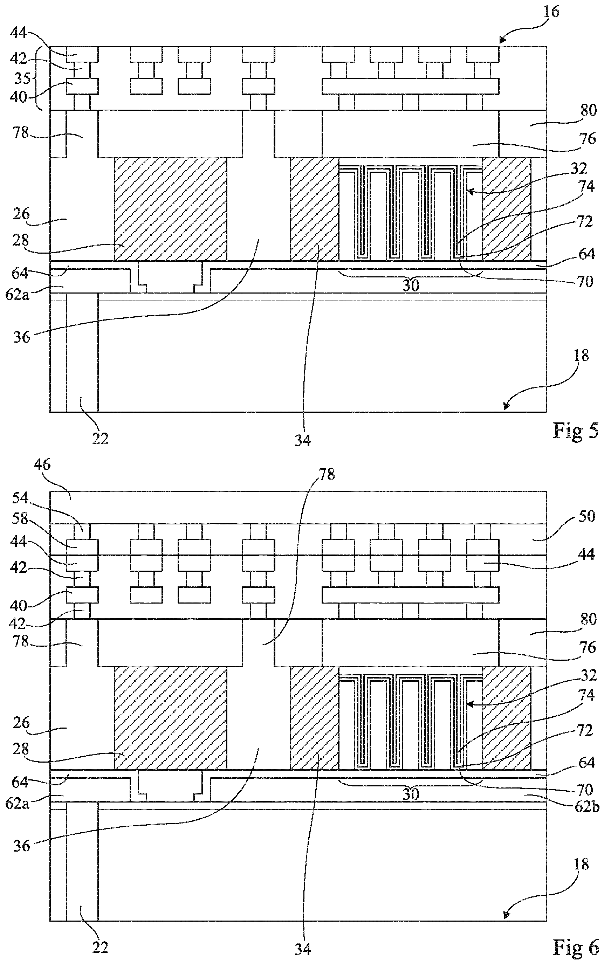

La figure 5 représente une étape d'un procédé de fabrication d'un mode de réalisation d'un dispositif électronique du type du dispositif de la figure 1.

Au cours de cette étape, le réseau d'interconnexion 35 est formé sur la face supérieure de l'interposeur, c'est-à-dire la face opposée à la face 18. La formation du réseau d'interconnexion est par exemple précédée de l'amincissement de la couche 80 de manière à découvrir les faces supérieures des régions 76 et 78.

Le réseau d'interconnexion 35 est par exemple formé par un procédé Damascène. Autrement dit, la formation du réseau d'interconnexion 35 comprend, pour chaque couche de l'empilement, la formation de la couche isolante, la gravure de la couche isolante aux emplacements des vias 42, des pistes 40 et des plots 44, la formation d'une couche conductrice sur la couche isolante de manière à remplir les emplacements gravés, et le retrait des portions de la couche conductrice situés hors des emplacements gravés.

La figure 6 représente une étape d'un procédé de fabrication d'un mode de réalisation d'un dispositif électronique du type du dispositif de la figure 1.

Au cours de cette étape, l'interposeur 12 est fixé à une puce 14. La puce 14 est par exemple formée parallèlement à la fabrication de l'interposeur. La formation de la puce 14 comprend la formation de composants électroniques dans un substrat semiconducteur 46. La formation de la puce 14 comprend en outre la formation du réseau d'interconnexion 48, c'est-à-dire la formation des couches isolantes 50, des pistes conductrices, des vias 54 et des plots 58.

Les plots 58 sont situés de manière à être en contact avec les plots 44 de l'interposeur 12 lorsque la puce 14 et l'interposeur sont fixés l'un à l'autre. Le contact entre les plots 58 et 44 permet la connexion électrique entre la puce 14 et l'interposeur 12 et permet le collage moléculaire entre la puce 14 et l'interposeur 12.

Le procédé de fabrication du dispositif 10 de la figure 1 comprend en outre la fabrication de la puce principale non représentée, ou le substrat BGA non représenté et sa fixation à la face 18 de l'interposeur de manière à être reliée électriquement à l'interposeur, et plus particulièrement aux extrémités inférieures des vias 22.

Des liaisons électriques peuvent ainsi être effectuées entre la face inférieure 18 de l'interposeur et la face supérieure 16 de l'interposeur, c'est-à-dire entre la puce principale non représentée et la puce 14, chaque liaison étant effectuée par l'intermédiaire d'un via 22, d'une portion 62a, d'une couche 64, d'une région 26, d'une région 78, de pistes 40, de vias 42 et d'un plot 44.

La puce 14 est de plus reliée aux bornes du condensateur 32. Une borne du condensateur 32, correspondant à la couche 70, est reliée à la puce 14 par l'intermédiaire d'une couche 64, d'une portion 62b, d'une région 36, d'une région 78, de vias 42, de pistes 40, et d'un plot 44. Une autre borne du condensateur 32, correspondant à la couche 74, est reliée à la puce 14 par l'intermédiaire d'une région 76, de vias 42, de pistes 40, d'un plot 44, et éventuellement d'un niveau de routage au niveau de la face inférieure de l'interposeur.

Un avantage des modes de réalisation décrits est la possibilité d'obtenir des capacités haute densité dans un interposeur, ce qui permet d'optimiser le transfert de puissance.

Un autre avantage des modes de réalisation décrits est que les condensateurs sont particulièrement proches des composants électroniques des puces fixées sur la face supérieure de l'interposeur.

Un autre avantage des modes de réalisation décrits est que la densité d'interconnexion entre l'interposeur et les puces fixées sur la face supérieure de l'interposeur est importante. En effet, l'utilisation des plots d'un réseau d'interconnexion pour former des connexions avec les puces et fixer les puces et l'interposeur par collage moléculaire permet d'ajouter les liaisons correspondant aux condensateurs sans augmenter la taille de l'interposeur.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Interposeur (12) comprenant des condensateurs (32) ayant une densité supérieure à 700 nF/mm^2, avantageusement supérieure à 1 µF/mm^2, l'interposeur étant adapté à être fixé à une puce (14) par collage hybride.

2. Interposeur selon la revendication 1, dans lequel l'interposeur comprend :
un substrat (20) traversé par des premiers vias conducteurs (22) ;
une première couche (24), recouvrant le substrat (20), dans laquelle sont situés les condensateurs (32) ; et
un réseau d'interconnexion (35) comprenant des plots (44) de contact adaptés au collage moléculaire.

3. Interposeur selon la revendication 1 ou 2, dans lequel les premiers vias (22) ont un diamètre compris entre 5 µm et 20 µm, avantageusement sensiblement égal à 10 µm, et une hauteur comprise entre 50 µm et 200 µm, avantageusement sensiblement égale à 100 µm.

4. Interposeur selon l'une quelconque des revendications 1 à 3, dans lequel la première couche (24) comprend des premières régions conductrices (26), chaque première région (26) étant en contact avec une extrémité d'un premier via (22), et étant reliée à un plot de contact (44) par des vias conducteurs (42) et pistes conductrices (40) du réseau d'interconnexion (35).

5. Interposeur selon la revendication 4, dans lequel les premières régions (26) sont entourées latéralement par des deuxièmes régions isolantes (28).

6. Interposeur selon l'une quelconque des revendications 1 à 5, dans lequel l'interposeur comprend :
des troisièmes régions (30) dans lesquelles sont situés les condensateurs (32),
des quatrièmes régions isolantes (34), chaque condensateur (32) étant entouré latéralement par une quatrième région isolante (34),
des cinquièmes régions (26) conductrices, chaque cinquième région (26) étant séparée d'une troisième région (30) par une quatrième région (34), et
des sixièmes régions conductrices (37), chaque sixième région (37) reliant une borne d'un condensateur (32) à une cinquième région (26), chaque cinquième région (26) étant reliée à un plot de contact (44) par des deuxièmes vias conducteurs (42) et pistes conductrices (40) du réseau d'interconnexion, une autre borne de chaque condensateur (32) étant reliée à un plot de contact (44) par des deuxièmes vias conducteurs (42) et pistes conductrices (40) du réseau d'interconnexion.

7. Interposeur selon la revendication 5 ou 6, dans lequel chaque région isolante (28, 34) de la première couche est en un métal anodisé.

8. Interposeur selon la revendication 6, dans lequel les condensateurs (32) comprennent un empilement d'une deuxième couche conductrice (70), d'une troisième couche isolante (72), d'une quatrième couche conductrice (74), chaque troisième région (30) étant en un métal anodisé comprenant une pluralité de cavités traversant ledit métal, l'empilement (70, 72, 74) recouvrant les parois desdites cavités.

9. Interposeur selon l'une quelconque des revendications 1 à 8, dans lequel l'interposeur (12) comprend, dans au moins une zone, une densité de plots (44) supérieure à 10^3 plots par mm^2.

10. Dispositif comprenant un interposeur (12) tel que décrit selon l'une quelconque des revendications 1 à 9 et au moins une première puce (14) fixée à une première face (16) de l'interposeur, la au moins une première puce (14) étant fixée à la première face (16) par collage moléculaire.

11. Procédé de fabrication d'un interposeur selon l'une quelconque des revendications 1 à 10, dans lequel la formation du condensateur (32) comprend :
- la formation d'une cinquième couche (68) en un matériau conducteur ;
- la formation de cavités à l'emplacement du condensateur (32) dans la cinquième couche (68) par un procédé de gravure anodique ; et
- la formation, de manière conforme, d'un empilement d'une couche conductrice (70), d'une couche isolante (72) et d'une couche conductrice (74) à l'emplacement du condensateur (32).

12. Procédé selon la revendication 11, dans lequel la formation des régions isolantes de la première couche est obtenue par un procédé de gravure anodique d'une partie de la cinquième couche.

13. Procédé selon la revendication 11 ou 12 dans son rattachement aux revendications 2 et 6, dans lequel le procédé comprend :
- la formation des premiers vias (22) dans le substrat (20) ;
- la formation d'une septième région conductrice (37) s'étendant de l'emplacement de chaque troisième région (30) à l'emplacement de la cinquième région (36) correspondante ;
- la formation du condensateur (32), de telle manière qu'une borne du condensateur soit en contact avec la septième région (37).

14. Procédé selon l'une quelconque des revendications 11 à 13, dans lequel la cinquième couche (68) est en aluminium.
